# EUROPÄISCHE PATENTSCHRIFT

(11) **EP 1 545 177 B1**
(45) Veröffentlichungstag und Bekanntmachung des Hinweises auf die Patenterteilung: **23.05.2007**
(21) Anmeldenummer: 04022904.9
(22) Anmeldetag: 25.09.2004
(51) Int. Cl.: H05K 5/00, H01H 43/02, H01H 13/70

(54) **Zentrierrahmen und Baugruppe umfassend den besagten**
Centering frame and module comprising it
Cadre de centrage et module le comprenant

(30) Priorität: 19.12.2003 DE 20319730 U
(43) Veröffentlichungstag der Anmeldung: 22.06.2005
(73) Patentinhaber: Electrolux Home Products Corporation N.V., 1930 Zaventem (BE)
(72) Erfinder: Huber, Alexander, 76694 Forst (DE)
(74) Vertreter: Baumgartl, Gerhard Willi

(56) Entgegenhaltungen:
- EP-A- 0 278 018
- DE-A1- 19 817 369
- US-A- 3 900 712

## Beschreibung

Die Erfindung bezieht sich auf eine Baugruppe, die ein Gehäuseteil und eine von dem Gehäuseteil abgedeckte Leiterplatte umfasst; (vgl. US-A-3 900 712 oder EP-A-0 278 018).

Derartige Baugruppen werden beispielsweise in Haushaltgeräten wie in einer Geschirrspülmaschine, einer Waschmaschine oder einem Wäschetrockner eingesetzt. Vorzugsweise im oberen Frontbereich oder auf der Oberseite derartiger Haushaltgeräte ist eine Bedienblende angeordnet, die neben einem Ein-/Aus-Schalter verschiedene andere Bedienelemente umfasst, um beispielsweise bestimmte Arbeitsprogramme des jeweiligen Haushaltgeräts ein- oder auszuschalten.

Hinter oder unterhalb der Bedienblende ist eine Bedienelektronik auf einer Leiterplatte integriert, auf der Schalter angeordnet sind, die durch die Bedienelemente betätigt werden. Die Leiterplatte ist über ein erstes vorderseitiges Gehäuseteil mit dem Rahmen des Haushaltgeräts verbunden und bildet zusammen mit einem zweiten rückseitigen Gehäuseteil eine Baugruppe.

Es ist die Aufgabe der Erfindung, eine Verbindung zwischen der Leiterplatte und dem vorderen Gehäuseteil zu schaffen, durch die eine sichere Bedienung der auf der Leiterplatte angeordneten Schalter gewährleistet wird.

Erfindungsgemäß wird diese Aufgabe bei einer Baugruppe der eingangs genannten Art dadurch gelöst, dass zwischen dem Gehäuseteil und der Leiterplatte ein Zentrierrahmen zum Zentrieren mindestens eines Bedienmittels vorhanden ist, das eine Bedienverbindung zwischen einem ersten Bedienelement auf dem Gehäuseteil und einem zweiten Bedienelement auf der Leiterplatte herstellt, wobei das mindestens eine Bedienmittel mit dem Gehäuseteil oder mit Leiterplatte fest verbunden ist.

Ein derartiger Zentrierrahmen stellt sicher, dass auf Druck reagierende federnd in dem vorderen Gehäuseteil gelagerte Stößel oder andere stabförmige Elemente, die zum Betätigen von auf der Leiterplatte angebrachten Schaltern dienen und die Bedienmittel bilden, spielfrei geführt werden und präzise auf einen Taster eines Schalters drücken, der seinerseits auf der Leiterplatte angebracht ist. Dabei ist die Höhe des Zentrierrahmens so bemessen, dass die Stößel einerseits die Distanz zwischen Gehäuseteil und der Leiterplatte überwinden, jedoch andererseits nicht die Taster der auf der Leiterplatte aufgebrachten Schalter überdrücken können.

In einer alternativen Ausgestaltung der Baugruppe ist vorgesehen, dass das mindestens eine Bedienmittel mit dem Gehäuseteil verbunden ist. Dabei ist in dem Gehäuseteil eine Feder durch ring- oder mäanderförmige Ausnehmungen in der Deckplatte ausgebildet und das Bedienmittel in Form eines Stößels einstückig mit der Feder aus demselben Material, insbesondere einem Kunststoffmaterial, hergestellt.

Alternativ kann auch in Verbindung mit der Leiterplatte und einem auf dieser angeordneten Schalter ein Stößel oder eine Stange verankert sein, durch den bzw. die sich die Betätigung eines Bedienelements auf der Bedienblende auf den Schalter übertragen lässt. Auch in diesem Fall findet die Bedienung des Schalters durch den Zentrierrahmen und eine in diesem eingebrachte Öffnung hindurch statt.

Ebenso bezieht sich die Erfindung auch auf einen Zentrierrahmen nach Anspruch 3, der zum Einsatz in einer oben beschriebenen Baugruppe geeignet ist.

Erfindungsgemäß ist ein derartiger Zentrierrahmen dadurch gekennzeichnet, dass er form- und/oder kraftschlüssig zwischen dem Gehäuseteil und der von dem Gehäuseteil abgedeckten Leiterplatte gehaltert ist.

Mit Vorteil ist der Zentrierrahmen so ausgebildet, dass er mindestens einen hohlzylinder- oder hohlkegelstumpfförmigen Vorsprung umfasst, durch den das mindestens eine Bedienmittel hindurchführbar ist. Der an dem Gehäuseteil angebrachte und vorzugsweise fest mit diesem verbundene Stößel wird durch den vorzugsweise hohlkegelförmigen Vorsprung derart hindurchgeführt, dass er bei der Montage zunächst durch die größere Fläche des Kegels in diesen eingeführt und anschließend durch die kleinere Fläche des Kegels hindurchgeführt wird, so dass er in Richtung zu dem Taster spielfrei justiert wird und diesen zielgenau trifft.

Mit Vorteil wird vorgesehen, dass zwischen dem Zentrierrahmen und dem Gehäuseteil und/oder zwischen dem Zentrierrahmen und der Leiterplatte ein insbesondere mit dem zentrierrahmen fest verbundenes Distanzelement zum Einhalten eines Mindestabstandes zwischen dem Zentrierrahmen und dem Gehäuseteil bzw. zu der Leiterplatte angeordnet ist. Das Distanzelement ist entsprechend der Länge des Stößels oder der Mehrzahl von Stößeln so angepasst, dass die Leiterplatte formstabil und ohne Beschädigungen beispielsweise an Seitenwänden des Gehäuseteils festgeklemmt werden kann und auch der Zentrierrahmen zwischen dem Gehäuseteil und der Leiterplatte Platz findet.

Vorzugsweise umfasst das Distanzelement eine Feder oder wird von einer Feder gebildet, durch die das Distanzelement innerhalb des Federweges elastisch gegenüber dem Gehäuseteil gelagert werden kann.

Um eine Beschädigung der Feder während der Montage des Zentrierrahmens oder während des Betriebs auszuschließen, umfasst das Distanzelement einen als Anschlag dienenden Abstandshalter, der die Feder gegen Überdrücken schützt.

Vorteilhafte Weiterbildungen der Erfindung ergeben sich auch aus der Beschreibung und den Zeichnungen.

Nachfolgend wird die Erfindung in einem Ausführungsbeispiel anhand der Zeichnungen näher erläutert. Diese zeigen:
- Fig. 1: ein Gehäusevorderteil mit einem auf der Innenseite des Gehäusevorderteils eingeklemmten Zentrierrahmen in perspektivischer Darstellung von hinten,
- Fig. 2: eine Vorderansicht einer Leiterplatte, ebenfalls in perspektivischer Darstellung,
- Fig. 3: das Gehäusevorderteil und das rückseitige Gehäuseteil im zusammengesetzten Zustand, ebenfalls in perspektivischer Darstellung,
- Fig. 4: eine perspektivische Explosionsdarstellung des Gehäusevorderteils, des Zentrierrahmens, der Leiterplatte und eines rückseitigen Gehäuseteils,
- Fig. 5: eine weitere perspektivische Vorderansicht der Leiterplatte, auf die zusätzlich der Zentrierrahmen aufgelegt ist,
- Fig. 6: eine perspektivische Draufsicht auf den Zentrierrahmen von der Rückseite,
- Fig. 7: eine Draufsicht auf die Vorderseite des zentrierrahmens,
- Fig. 8: eine Seitenansicht des zentrierrahmens und
- Fig. 9: eine Draufsicht auf die Rückseite des Zentrierrahmens.

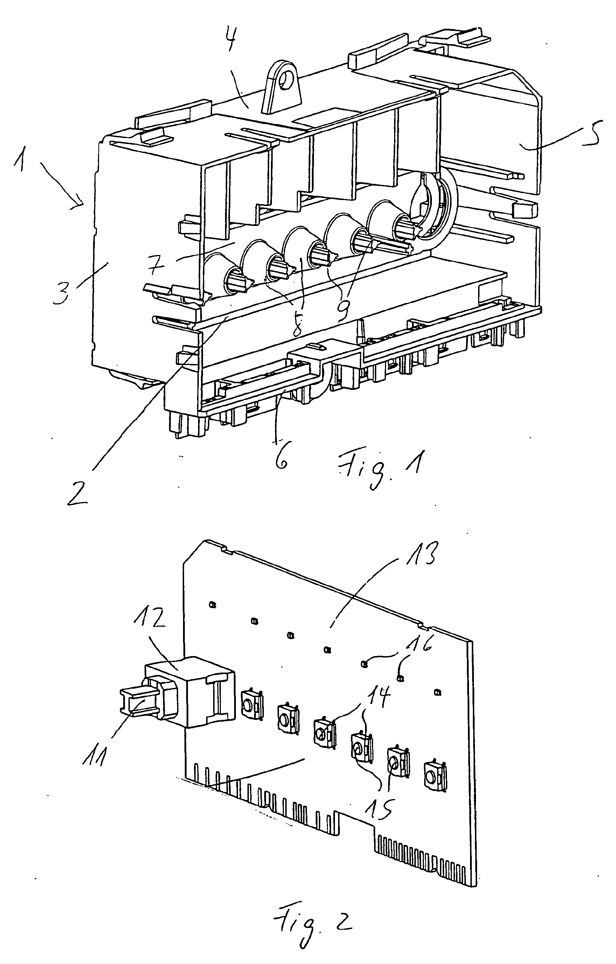

Ein Gehäusevorderteil 1 (Fig. 1) ist mit einer vorderen Platte 2 hinter einer Bedienblende eines Haushaltgeräts angeordnet und weist vier im wesentlichen rechteckig zueinander angeordnete Seitenteile 3 bis 6 auf, die von der Bedienblende weg in das Innere des Gehäuses des Haushaltsgeräts ragen. In dem auf diese Weise von dem Gehäusevorderteil 1 gebildeten, nach hinten offenen Raum ist ein Zentrierrahmen 7 gelagert. Der Zentrierrahmen 7 weist sechs in Reihe nebeneinanderliegende und ebenfalls nach hinten ragende kegelstumpfförmige Durchlässe 8 auf, durch die Stößel 9 hindurchragen. Dabei bilden die Durchlässe 8 aufgrund ihrer nach hinten konisch zusammenlaufenden oder hohlkegelstumpfförmig vorspringenden Form eine Führung für die Stößel oder Zapfen 9.

Ferner umfasst der Zentrierrahmen 7 einen im wesentlichen kreisförmigen Durchbruch 10. Dieser ist geeignet für einen Stößel 11 (Fig. 2). Der Stößel 11 ist auf einem Ein-/Aus-Schalter 12 aufgebracht, der seinerseits auf der Vorderseite einer Leiterplatte 13 angeordnet ist.

Neben dem Ein-/Aus-Schalter 12 sind auf der Leiterplatte 13 in einer Reihe nebeneinander sechs Mikroschalter 14 mit jeweils einem Taster 15 angebracht. Die Taster 15 werden jeweils durch die Stößel 9 betätigt. Daneben können auf der Leiterplatte 13 andere Bauelemente angeordnet sein, wie beispielsweise Leuchtdioden 16.

Die Stößel 9 (Fig. 3) sind auf dem Gehäusevorderteil 1 in der Weise ausgebildet, dass sie an ihrer Vorderseite fluchtend mit der Platte 2 oder gegenüber dieser nach hinten zurückgesetzt mit beispielsweise drei kreisbogenförmigen Elementen 17 verbunden sind. Diese durchsetzen jeweils einen den Stößel 9 kreisförmig umgebenden Durchbruch 18 in dem Gehäusevorderteil 1 und sind am Rand der Durchbrüche 18 jeweils mit der Platte 2 verbunden.

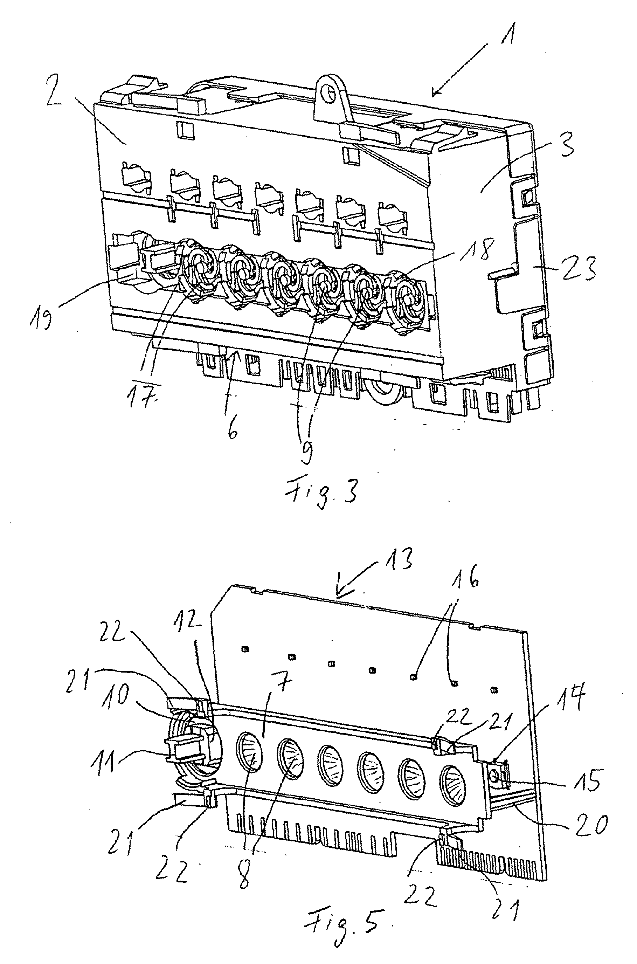

Der Stößel 11 ist so lang, dass er durch den Durchbruch 10 in dem Zentrierrahmen 7 (Fig. 5) hindurchtritt und zusätzlich durch einen Durchbruch 19 (Fig. 3) in dem Gehäusevorderteil 1 hindurchragt.

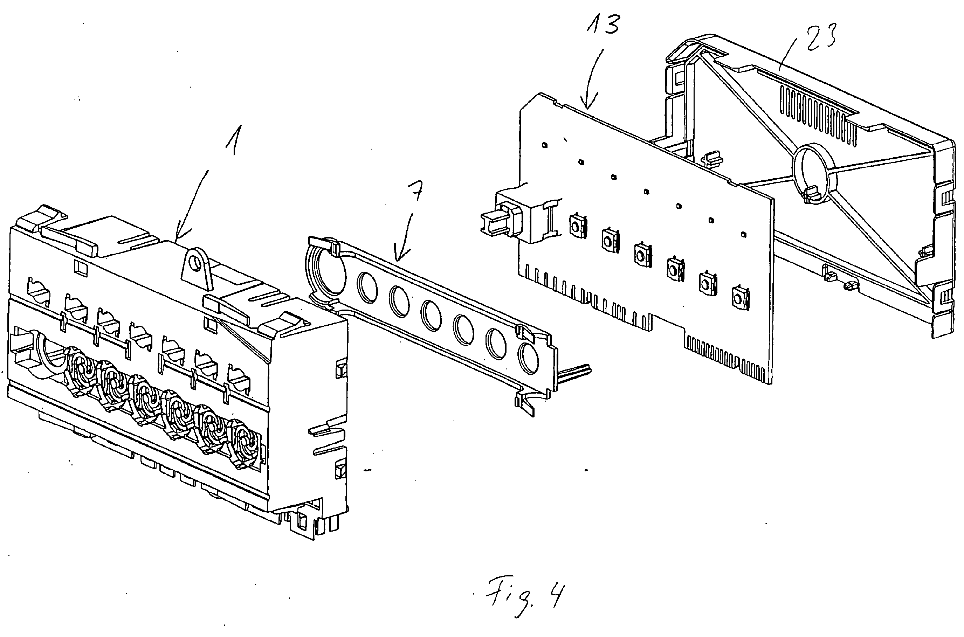

Zur Einhaltung eines gewünschten Abstands zur Leiterplatte 13 trägt der Zentrierrahmen 7 auf seiner Rückseite zwei stabförmige Distanzelemente 20 (Fig. 4, 5, 6, 8).

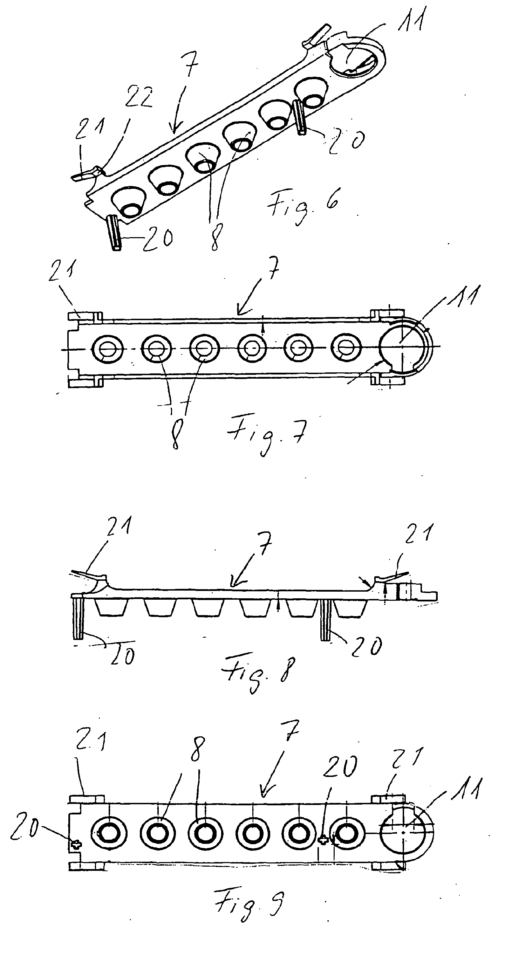

Andererseits ist der Zentrierrahmen 7 auf seiner, dem Gehäusevorderteil 1 zugewandten Vorderseite mit elastisch federnden Elementen 21 (Fig. 5 - 9) ausgestattet, die eine innerhalb des Federweges der Elemente 21 flexible, elastische und daher stabile Lage des Zentrierrahmens 7 zwischen dem Gehäusevorderteil 1 und der Leiterplatte 13 ermöglichen. Um zu verhindern, dass die Elemente 21 infolge von Überlastung von dem Zentrierrahmen 7 abbrechen, sind Abstandshalter 22 neben den Elementen 21 angebracht, die bei einer der Höhe der Abstandshalter 22 entsprechenden Durchbiegung der Elemente 21 deren Federweg begrenzen.

Die Leiterplatte 13 wird zusammen mit dem Zentrierrahmen 7 zwischen dem Gehäusevorderteil 1 und einem rückseitigen Gehäuseteil 23 (Fig. 3, 4) mit hoher Genauigkeit positioniert, wobei Ungenauigkeiten und Abweichungen von der Führung der Stößel 9 innerhalb des Gehäusevorderteils 1 sowie des auf der Leiterplatte 13 angebrachten Stößels 11 durch den Zentrierrahmen 7 und insbesondere durch die auf diesem aufgebrachten konisch in Richtung zu der Leiterplatte 13 vorspringenden Durchlässe 8 ausgeglichen.

Es versteht sich, dass an 'dem Zentrierrahmen 7 auch in Richtung zu der Leiterplatte 13 elastisch federnde Vorsprünge anstelle der stabförmigen Distanzstücke 20 angebracht werden können, falls dadurch die stabile Lage der Leiterplatte 13 verbessert und die Bruchfestigkeit der gesamten Baugruppe erhöht wird.

## Patentansprüche

1. Baugruppe, umfassend ein Gehäuseteil (1), eine von dem Gehäuseteil (1) abgedeckte Leiterplatte (13) und einen zwischen dem Gehäuseteil (1) und der Leiterplatte (13) eingebrachten Zentrierrahmen (7) zum Zentrieren mindestens eines Bedienmittels, das eine Bedienverbindung zwischen einem ersten Bedienelement auf dem Gehäuseteil (1) und einem zweiten Bedienelement (12, 15) auf der Leiterplatte (13) herstellt, wobei das mindestens eine Bedienmittel (9, 11) mit dem Gehäuseteil (1) oder mit der Leiterplatte (13) fest verbunden ist.

2. Baugruppe nach Anspruch 1, **dadurch gekennzeichnet, dass** das mindestens eine Bedienmittel als ein federnd mit einer Platte (2) des Gehäuseteils (1) verbundener Stab (9) ausgebildet ist und durch den Zentrierrahmen (7) hindurch einen Taster (15) eines auf der leiterplatte (13) angebrachten Schalters, insbesondere eines Mikroschalters (14), betätigt.

3. Zentrierrahmen (7) zum Einsatz in einer Baugruppe nach einem der Ansprüche 1 oder 2, **dadurch gekennzeichnet, dass** er form- und/oder kraftschlüssig zwischen dem Gehäuseteil (1) und der von dem Gehäuseteil (1) abgedeckten Leiterplatte (13) gehaltert ist.

4. Zentrierrahmen (7) nach Anspruch 3, **dadurch gekennzeichnet, dass** er mindestens einen hohlzylinder- oder hohlkegelstumpfförmigen Vorsprung (8) umfasst, durch den das mindestens eine Bedienmittel (9) hindurchführbar ist.

5. Zentrierrahmen (7) nach Anspruch 3 oder 4, **dadurch gekennzeichnet, dass** zwischen dem Zentrierrahmen (7) und dem Gehäuseteil (1) und/oder zwischen dem Zentrierrahmen (7) und der Leiterplatte (13) ein insbesondere mit dem Zentrierrahmen (7) fest verbundenes Distanzelement (20, 21) zum Einhalten eines Mindestabstands zwischen dem Zentrierrahmen (7) und dem Gehäuseteil (1) bzw. zu der Leiterplatte (13) angeordnet ist.

6. Zentrierrahmen (7) nach Anspruch 5, **dadurch gekennzeichnet, dass** das Distanzelement eine Feder umfasst oder von einer Feder (21) gebildet wird.

7. Zentrierrahmen (7) nach Anspruch 6, **dadurch gekennzeichnet, dass** das Distanzelement einen Abstandshalter (22) umfasst, der die Feder (21) gegen Überdrücken schützt.

## Claims

1. Assembly comprising a housing part (1), a printed circuit board (13) covered by the housing part (1) and a centering frame (7) introduced between the housing part (1) and the printed circuit board (13) for centering at least one operating means, which produces an operating connection between a first operating element on the housing part (1) and a second operating element (12, 15) on the printed circuit board (13), wherein the at least one operating means (9, 11) is firmly connected to the housing part (1) or to the printed circuit board (13).

2. Assembly according to claim 1, **characterised in that** the at least one operating means is designed as a rod (9) connected resiliently to a panel (2) of the housing part (1) and actuates a key (15) of a switch, in particular a microswitch (14), attached to the printed circuit board (13) through the centering frame (7).

3. Centering frame (7) for use in an assembly according to one of claims I or 2, **characterised in that** it is mounted positively and/or non-positively between the housing part (1) and the printed circuit board (13) covered by the housing part (1).

4. Centering frame (7) according to claim 3, **characterised in that** it comprises at least one hollow-cylindrical or hollow-frustum-shaped projection (8), through which the at least one operating means (9) can be passed.

5. Centering frame (7) according to claim 3 or 4, **characterised in that** a spacer element (20, 21) firmly connected in particular to the centering frame (7) for maintaining a minimum distance between the centering frame (7) and the housing part (1) or from the printed circuit board (13) is arranged between the centering frame (7) and the housing part (1) and/or between the centering frame (7) and the printed circuit board (13).

6. Centering frame (7) according to claim 5, **characterised in that** the spacer element comprises a spring or is formed by a spring (21).

7. Centering frame (7) according to claim 6, **characterised in that** the spacer element comprises a spacer (22), which protects the spring (21) against over-pressing.

## Revendications

1. Module, comprenant une partie de boîtier (1), une carte imprimée (13) recouverte par la partie de boîtier (1) et un cadre de centrage (7) placé entre la partie de boîtier (1) et la carte imprimée (13) pour le centrage d'au moins un moyen de commande qui établit une liaison de commande entre un premier élément de commande sur la partie de boîtier (1) et un deuxième élément de commande (12, 15) sur la carte imprimée (13), où au moins un moyen de commande (9, 11) est relié fixement à la partie de boîtier (1) ou à la carte imprimée (13).

2. Module selon la revendication 1, **caractérisé en ce qu'**au moins un moyen de commande est réalisé comme une tige (9) reliée élastiquement avec une plaque (2) de la partie de boîtier (1) et actionne à travers le cadre de centrage (7) une touche (15) d'un commutateur monté sur la carte imprimée (13), en particulier d'un microcommutateur (14).

3. Cadre de centrage (7) pour utilisation dans un module selon l'une des revendications 1 ou 2, **caractérisé en ce qu'**il est retenu par concordance des formes et/ou par force entre la partie de boîtier (1) et la carte imprimée (13) recouverte par la partie de boîtier (1).

4. Cadre de centrage (7) selon la revendication 3, **caractérisé en ce qu'**il comprend au moins une saillie en forme de cylindre creux ou tronconique creuse (8) à travers laquelle au moins un moyen de commande (9) peut être passé.

5. Cadre de centrage (7) selon la revendication 3 ou 4, **caractérisé en ce qu'**il est disposé entre le cadre de centrage (7) et la partie de boîtier (1) et/ou entre le cadre de centrage (7) et la carte imprimée (13) un élément d'écartement (20, 21) relié fixement au cadre de centrage (7) pour conserver un écart minimal entre le cadre de centrage (7) et la partie de boîtier (1) respectivement à la carte imprimée (13).

6. Cadre de centrage (7) selon la revendication 5, **caractérisé en ce que** l'élément d'écartement comprend un ressort ou est formé par un ressort (21).

7. Cadre de centrage (7) selon la revendication 6, **caractérisé en ce que** l'élément d'écartement comprend un élément de maintien d'écart (22) qui protège le ressort (21) à l'encontre d'une pression excessive.
